Europäisches Patentamt

European Patent Office

Office européen des brevets

(11) Veröffentlichungsnummer: **0 212 341**
**A2**

(12) # EUROPÄISCHE PATENTANMELDUNG

(21) Anmeldenummer: **86110301.8**

(51) Int. Cl.⁴: **H 03 C 3/42**

(22) Anmeldetag: **25.07.86**

(30) Priorität: **12.08.85 DE 3528920**

(43) Veröffentlichungstag der Anmeldung: **04.03.87**
**Patentblatt 87/10**

(84) Benannte Vertragsstaaten: **AT DE GB NL**

(71) Anmelder: **Siemens Aktiengesellschaft Berlin und München, Wittelsbacherplatz 2, D-8000 München 2 (DE)**

(72) Erfinder: **Kloeber, Peter, Dipl.-Ing., Uhdestrasse 20, D-8000 München 71 (DE)**

(54) **Kompensationsschaltung für modulierbare Schwingquarze konstanter Modulationssteilheit.**

(57) Mit einer solchen Kompensationsschaltung soll erreicht werden, daß in Oszillatorschaltungen mit einem Schwingquarz herstellungsbedingte Abweichungen der Quarzdaten ausgeglichen werden.

Die Erfindung sieht hierzu vor, daß bei einem Schwingquarz in Serienresonanz eine in Serie geschaltete Festkapazität (C1′) und eine weitere zu dieser Serienschaltung parallel geschaltete Festkapazität (Co′) angeordnet sind.

Siemens Aktiengesellschaft   -1-   Unser Zeichen
Berlin und München                    VPA **85** P 1 5 2 6 E

## Kompensationsschaltung für modulierbare Schwingquarze konstanter Modulationssteilheit

Die Erfindung bezieht sich auf eine Kompensationsschaltung für modulierbare Schwingquarze konstanter Modulationssteilheit, insbesondere zur Verwendung in Funksystemen.

In bestimmten Funksystemen, deren Frequenzstabilität von schwingquarzgesteuerten Oszillatorschaltungen abgeleitet wird, besteht nämlich die Notwendigkeit, eine Frequenzmodulation des gesendeten Signals durch Verändern der Resonanzbedingungen des Quarzes durchzuführen. Dies kann durch Parallel- oder Serienschalten einer elektronisch veränderbaren Kapazität, das sog. Ziehen eines Quarzes zum Beispiel durch eine Varaktordiode (Kapazitätsdiode) geschehen, wobei der Pegel des an die veränderbare Kapazität angelegten beispielsweise wechselfrequenten Ansteuersignals den Hub der Frequenzmodulation bestimmt.

Bei einem notwendig werdenden Wechsel des Quarzes bei unveränderter Oszillatorschaltung, z.B. bei Umstellung auf einen anderen Frequenzkanal oder Defekt eines Quarzes, kann sich infolge der herstellungsbedingten unterschiedlichen Quarzdaten das Resonanz- und Ziehbarkeitsverhalten der einzelnen Quarze zum Teil erheblich ändern, selbst wenn diese gleiche nominelle Resonanzfrequenz aufweisen. Dabei weicht der FM-Hub sowohl in seinem absoluten Betrag (Modulationssteilheit) als auch über die Frequenz des niederfrequenten Ansteuersignals (Frequenzgang der Modulationssteilheit) von Quarz zu Quarz ab.

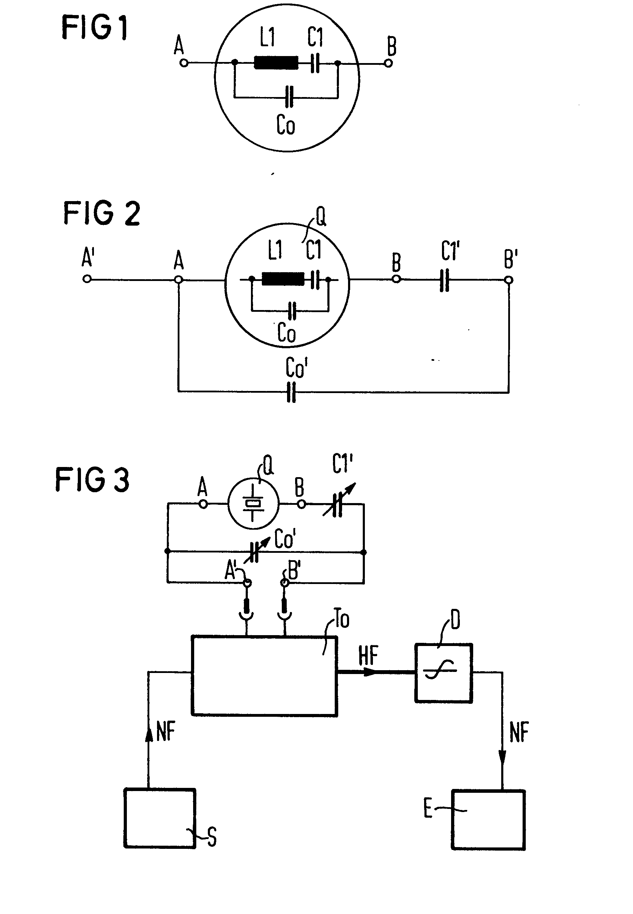

Nach dem vereinfachten Ersatzschaltbild eines Quarzes in Serienresonanz, wie es in Fig. 1 dargestellt ist, bilden

9. Aug. 1985 / Klu 1 Kdg

die dynamische Kapazität C1 und Induktivität L1 den gedachten Schwingkreis des Quarzes. Die zur Serienschaltung aus C1 und L1 parallel liegende Kapazität Co stellt die gegen die Anschlußklemmen A und B des Quarzes gemessene statische Kapazität dar, die u.a. von Form und Größe des Quarzgehäuses bestimmt wird.

In üblichen Oszillatorschaltungen, beispielsweise einer FM-modulierbaren Oszillatorschaltung mit einem Schwingquarz in Serienresonanz, zeigt es sich, daß die dynamische Kapazität C1 einen bestimmenden Wert für die Modulationssteilheit des Quarzes darstellt, die statische Kapazität Co dagegen den Frequenzgang der Modulationssteilheit beeinflußt. Selbst bei engtolerierten Quarzdaten sind die herstellungsbedingten Abweichungen der einzelnen Quarze desselben Typs für die Kapazitäten C1 und Co so groß, daß die daraus resultierenden Schwankungen der Modulationssteilheit, insbesondere bei relativ in der Frequenz breitbandigen Ansteuerungssignalen die Spezifikationen überschreiten.

Der Erfindung liegt die Aufgabe zugrunde, eine Lösung anzugeben, mit der solche Abweichungen bei Quarzen in Oszillatorschaltungen in einfacher Weise ausgeglichen werden können.

Diese Aufgabe wird gemäß der Erfindung in der Weise gelöst, daß bei einem Schwingquarz in Serienresonanz eine in Serie geschaltete Festkapazität und eine weitere, zur Serienschaltung aus Schwingquarz und dieser Festkapazität parallel geschaltete Festkapazität angeordnet sind.

Vorteilhafte Ausgestaltungen und Weiterbildungen des Erfindungsgegenstandes sind in den Unteransprüchen angegeben.

Nachstehend wird die Erfindung anhand eines in der Zeichnung dargestellten Ausführungsbeispiels näher erläutert.

Es zeigt

Fig. 1 das vereinfachte Ersatzschaltbild eines Quarzes in
Serienresonanz,

Fig. 2 das Ersatzschaltbild des Quarzes mit den erfindungsgemäßen Kompensationselementen und

Fig. 3 eine Testschaltung zur Bestimmung der Kompensationselemente.

Die Schaltung nach Fig. 2 enthält eine Kompensation der
Quarzwerte C1 (dynamische Kapazität) und Co (statische
Kapazität) durch eine in Serie geschaltete Festkapazität
C1' und eine zu dieser Serienschaltung aus Schwingquarz
Q und Festkapazität C1' parallel geschaltete, an der Anschlußklemme A des Quarzes Q und der Schaltungsklemme B'
angeschlossene Festkapazität Co'. Mit A' ist die zweite
Anschlußklemme der Gesamtschaltung, mit B die zweite Anschlußklemme des Quarzes Q bezeichnet. Dabei werden für
jeden Schwingkreis die individuelle Serienkapazität C1'
bestimmt, die die Modulationssteilheit definiert verringert,
sowie die ebenfalls individuelle Parallelkapazität Co', mit
der die Modulationssteilheit über der Frequenz des Ansteuersignals (Frequenzgang) geebnet werden kann.

Die vorstehend beschriebene Quarzschaltung wird in Form
einer Unterbaugruppe, die den Quarz und die jeweils zugeordneten Kapazitäten C1' und Co' enthält, in einem entsprechenden Funksystem, beispielsweise einem Richtfunksystem verwendet. Dabei wird beispielsweise der zur Stabilisierung des Mikrowellensignals benutzte Quarzoszillator
in einer Phasenvergleichs- und Regelschaltung als Referenzfrequenzoszillator verwendet und zugleich zur Übertragung
eines sog. Dienstkanals zwischen 0 und 20 kHz in der
Frequenz moduliert. Die Mikrowellensendefrequenz stellt
dabei in bezug auf ihren Absolutwert und ihren FM-Hub
ein festes Vielfaches der Referenzfrequenz des Sendeoszillators dar. Der frequenzbestimmende Schwingquarz kann

0212341

durch die erfindungsgemäßen Maßnahmen vom Anwender ohne Nachgleich der Oszillatorschaltung beliebig vertauscht über ein bestimmtes Kanalfrequenzraster gewechselt werden, wobei der Modulationshub für alle Quarze eine größtmögliche Konstanz aufweist.

Die Kapazitäten C1' und Co' können in vorteilhafter Weise für jeden Quarz gesondert in einer entsprechenden Testoszillatorschaltung bestimmt und in eine kleine Leiterplatte zusammen mit dem Quarz eingelötet werden. Diese Quarzbaugruppe wird dann als Steckmodul in die Oszillatorschaltung eingesteckt. Für die Kapazitäten C1' und Co' können dabei auch Trimmerkondensatoren verwendet werden.

Fig. 3 zeigt eine entsprechende Meßschaltung zur Bestimmung der Kapazitätswerte von C1' und Co'. Der Testoszillator TO wird hierbei an den Schwingquarz angeschlossen (an den Anschlußklemmen A', B') und die Abstimmung vorgenommen. Hierzu wird der Testoszillator TO mit einem niederfrequenten Signal veränderbarer Frequenz, jedoch konstanter Amplitude eines Pegelsenders S moduliert und ausgangsseitig mit einem FM-Demodulator fest verbunden, dessen Ausgangssignal ein Maß für die Verzerrungen der Modulationssteilheit darstellt. Dies wird in einem Pegelempfänger E erfaßt. Bei geeigneter Wahl der Kapazitäten C1' und Co' werden bei der Funkübertragung der absolute Betrag und der Frequenzgang des demodulierten Signals weitgehend konstant gehalten.

3 Patentansprüche

3 Figuren

Patentansprüche

1. Kompensationsschaltung für modulierbare Schwingquarze konstanter Modulationssteilheit, dadurch gekennzeichnet, daß bei einem Schwingquarz (Q) in Serienresonanz eine in Serie geschaltete Festkapazität (C1') und eine weitere zur Serienschaltung aus Schwingquarz (Q) und dieser Festkapazität (C1') parallel geschaltete Festkapazität (Co') angeordnet sind.

2. Kompensationsschaltung nach Anspruch 1, dadurch gekennzeichnet, daß der Schwingquarz (Q) und die jeweils zugeordnete Serien- und Parallelkapazität (C1' bzw. Co') eine gemeinsame Baueinheit bilden.

3. Kompensationsschaltung nach Anspruch 1 oder 2, dadurch gekennzeichnet, daß die für die Kompensation verwendeten Kapazitäten (C1',Co') in einer Testoszillatorschaltung bestimmt werden.

1/1 · 0212341

FIG 1

FIG 2

FIG 3